# EUROPEAN PATENT APPLICATION

(11) **EP 1 953 821 A2**
(43) Date of publication of application: **06.08.2008**
(21) Application number: 08150844.2
(22) Date of filing: 30.01.2008
(51) Int. Cl.: H01L 23/498

(54) **Semiconductor package substrate**

(30) Priority: 02.02.2007 TW 96103832
(71) Applicant: Phoenix Precision Technology Corporation, Hsin-Chu (TW)
(72) Inventor: Hsu, Shih-Ping, Hsin-Chu (TW)
(74) Representative: Helino, Timo Kalervo

(57) **Abstract**

A semiconductor package substrate structure includes a circuit board with a plurality of first electrically connecting pads formed on at least a surface of the circuit board, conductive posts formed on the first electrically connecting pads, and an insulative protection layer formed on the surface of the circuit board and formed with openings for completely exposing the conductive posts. The conductive posts protrude from the substrate, thereby facilitating the electrical connection between the conductive posts and a semiconductor chip, and enhancing the quality and reliability of a subsequent packaging process.

## Description

### FIELD OF THE INVENTION

The present invention relates to a semiconductor package substrate structure, and more particularly, to a method of forming conductive elements on electrical electrically connecting pads on the surface of a circuit board, for external electrical connection.

### BACKGROUND OF THE INVENTION

In the current flip-chip techniques, a semiconductor chip of IC is provided with electrode pads and a circuit board is provided with electrically connecting pads corresponding to the electrode pads, and the solder structures or the structures made from other conductive adhesive materials are formed between the electrode pads of the semiconductor chip and the corresponding electrically connecting pads of the circuit board so as to provide electrical connection and mechanical connection between the semiconductor chip and the circuit board.

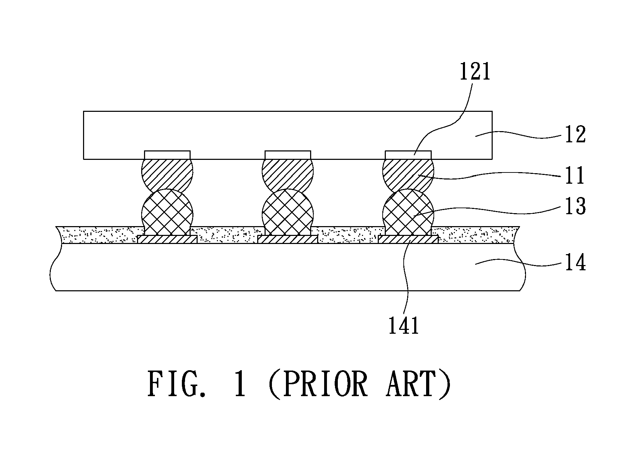

Referring to FIG. 1, a plurality of metallic bumps 11 are formed on electrode pads 121 of a semiconductor chip 12, and a plurality of pre-solder structures 13 are formed on electrically connecting pads 141 of a circuit board 14. The metallic bumps 11 formed on the electrode pads 121 of the semiconductor chip 12 are mounted on the pre-solder structures 13 of the circuit board 14 using the flip-chip technique, and then at an appropriate reflow temperature for melting the pre-solder structures 13, the pre-solder structures 13 are reflowed to the corresponding metallic bumps 11, and thereby the semiconductor chip 12 are electrically connected to the circuit board 14.

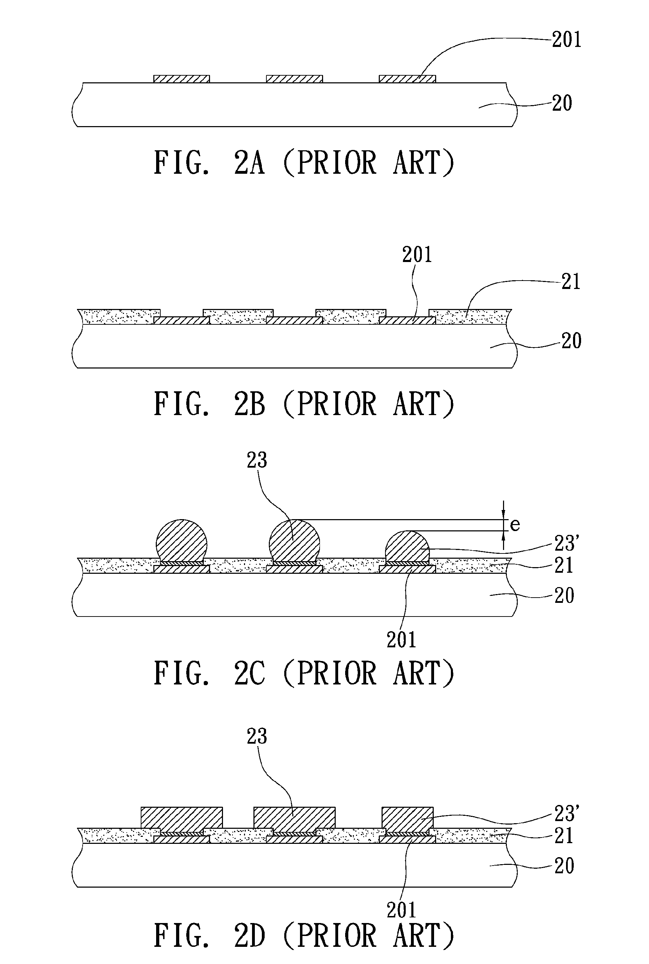

Referring to Figs. 2A to 2D, FIGs. 2A to 2D are cross-sectional schematic views illustrating the formation of pre-solder structures on a circuit board according to a conventional method.

As shown in FIG. 2A, a circuit board 20 having electrically connecting pads 201 on a surface thereof is provided.

As shown in FIG. 2B, an insulative protection layer 21 (such as a solder mask layer) is formed on the surface of the circuit board 20, and the insulative protection layer 21 exposes the electrically connecting pads 201 by the exposure and the development processes.

As shown in FIG. 2C, an adhesive layer 22 is formed on the electrically connecting pads 201 on the surface of the circuit board 20, and an electroplating process or a printing process is further performed to form pre-solders 23. However, there still exist some problems in the flip-chip techniques. For example, as a substrate used for FCCSP (flip-chip chips scale package) is thin enough to be easily bended. In addition, a strip-shaped circuit board having a plurality of substrate units can cause problems such as complicated fabrication process of pre-solders, low production yield and long cycle time. Further, not the heights of all the pre-solders 23 on the electrically connecting pads 201 are at the same level (i.e., a part of the pre-solders 23' is lower or higher than the normal pre-solders 23 and a height difference "e" exists therebetween).

As shown in Fig. 2D, in order to overcome the unevenness problem among the conductive elements 23 on the circuit board 20, a coining process is employed to level out all of the pre-solders 23 to the same height. However, the coining process cannot level out all of the pre-solders 23 at once. The process can only level out the pre-solders 23 parts by parts, which, however, is time-consuming and costly.

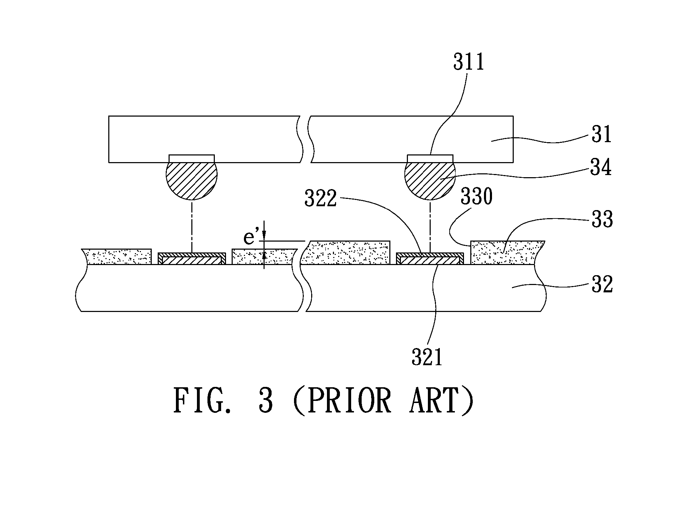

Referring to FIG. 3, FIG. 3 shows a schematic view of a semiconductor chip 31 being electrically connected to the circuit board 32. The circuit board 32 has electrically connecting pads 321 formed on surface thereof by the flip-chip technique. An insulative protection layer 33 is formed on the surface of the circuit board 32, and a plurality of openings 330 are formed in the insulative protection layer 33 so as to expose parts of surfaces of the electrically connecting pads 321. An adhesive layer 322 is formed on surfaces of the electrically connecting pads 321. However, the adhesive layer 322 is still lower than the insulative protection layer 33. The semiconductor chip 31 has electrode pads 311 formed on a surface thereof. A metallic bump 34 is formed on surfaces of each of the electrode pads 311, so that the metallic bumps 34 on the semiconductor chip 31 correspond to the electrically connecting pads 321 of the circuit board 32. A reflow process is then performed to allow the metallic bumps 34 to be electrically connected to the surfaces of the electrically connecting pads 321 of the circuit board 32.

However, the insulative protection layer 33 is not completely even (i.e., part of the insulative protection layer 33 may be higher or lower than the insulative protection layer), as indicated by a height difference "e"' exists therebetween. As a result, the openings 330 are formed in the insulative protection layer 33 to expose the electrically connecting pads 321, so that the metallic bumps 34 on the semiconductor chip 31 are electrically connected with the electrically connecting pads 321. In this case, problems such as deviation or poor electrical connection between the semiconductor chip and the circuit board are likely to occur. These problems are particularly serious for NSMD (non-solder mask defined) products.

### SUMMARY OF THE INVENTION

In view of the aforesaid drawbacks, it is therefore an objective of the present invention to provide a semiconductor package substrate, wherein flat conductive posts are formed to ensure the reliability of a subsequent packaging process.

It is another objective of the present invention to provide a semiconductor package substrate, wherein conductive posts are formed with heights greater than that of the insulative protection layer so as to facilitate electrical connection to the bumps adapted for electrical connection with a semiconductor chip.

In accordance with the foregoing and other objectives, the present invention proposes a semiconductor package substrate structure, comprising: a circuit board having a plurality of first electrically connecting pads formed on at least a surface of the circuit board; conductive posts formed on surfaces of the first electrically connecting pads by electroplating; and an insulative protection layer formed on the surface of the circuit board and formed with openings for completely exposing the conductive posts. The conductive posts protrude from the insulative protection layer to enable a semiconductor chip to be mounted.

The semiconductor package substrate structure further comprises a conductive layer formed between the circuit board and the first electrically connecting pads. The conductive layer may be made of a material selected from the group consisting of Cu, Sn, Ni, Cr, Ti and Cu-Cr alloy, or a conductive polymer. Preferably, the conductive layer is made of copper foil or electroless copper.

Further, traces and second electrically connecting pads may be formed on surface of the circuit board, and a conductive layer is formed between the circuit board and the traces, the circuit board and the first electrically connecting pads, and the circuit board and the second electrically connecting pads.

The first electrically connecting pads are solder pads and conductive posts are formed on the surfaces of thereof, whereas the second electrically connecting pads are wire bonding pads and are below than the surface of the insulative protection layer. An adhesive layer may be formed on the surfaces of the conductive posts and the second electrically connecting pads to prevent oxidation of the conductive posts and the second electrically connecting pads, while improving the quality of electrical connection to other elements. Alternatively, conductive elements may be directly formed on the surfaces of the conductive posts.

The insulative protection layer is made of a photosensitive dielectric material such as a solder mask. The photosensitive dielectric material is in the form of a dry film or liquid. The liquid photosensitive dielectric material is formed on the surface of the circuit board by a printing process or a non-printing process. The non-printing process can be one of roller coating, spray coating, dipping coating and spin coating. The dry-film photosensitive dielectric material is adhered onto surface of the circuit board. The insulative protection layer further comprises another opening for exposing the second electrically connecting pads.

Accordingly, the present invention involving forming a conductive layer on the surface of a circuit board, and then forming electrically connecting pads and conductive posts through the conductive layer by electroplating. After the conductive layer is removed, an insulative protection layer is formed on the surfaces of the circuit board and the conductive posts. Since the conductive posts are higher than the circuit board, the conductive posts can be completely exposed to become NSMD (non-solder mask defined) solder pads after the insulative protection layer is patterned; meanwhile, the conductive posts protrude from the insulative protection layer. As a result, the conductive posts can easily be electrically connected to the bumps adapted for electrical connection with a semiconductor chip, and the quality and reliability of a subsequent packaging process is ensured.

### BRIEF DESCRIPTION OF THE DRAWINGS

FIG. 1 is a cross-sectional view of a conventional flip chip structure;
FIGs. 2A to 2D are cross-sectional views illustrating the formation of pre-solder structures on a circuit board according to a conventional method;
FIG. 3 is a schematic view of a circuit board and a semiconductor chip being electrically connected to the circuit board using the flip-chip technology;
FIGs. 4A to 4I are cross-sectional schematic views illustrating a semiconductor package substrate according to the first embodiment of the present invention;
FIG. 4I' is another cross-sectional schematic view showing an alterative embodiment of FIG. 4I;
FIGs. 5A to 5I are cross-sectional schematic views illustrating a semiconductor package substrate according to the second embodiment of the present invention;
FIG. 5I' is a cross-sectional schematic view showing an alterative embodiment of FIG. 5I;
FIGs. 6A to 6I are cross-sectional schematic views illustrating a semiconductor package substrate according to the third embodiment of the present invention; and
FIGs. 7A to 7I are cross-sectional schematic views showing a semiconductor package substrate according to the fourth embodiment of the present invention.

### DETAILED DESCRIPTION OF THE PREFERRED EMBODIMENTS

The present invention is described in the following so that one skilled in the art can easily understand other advantages and effects of the present invention.

### FIRST EMBODIMENT

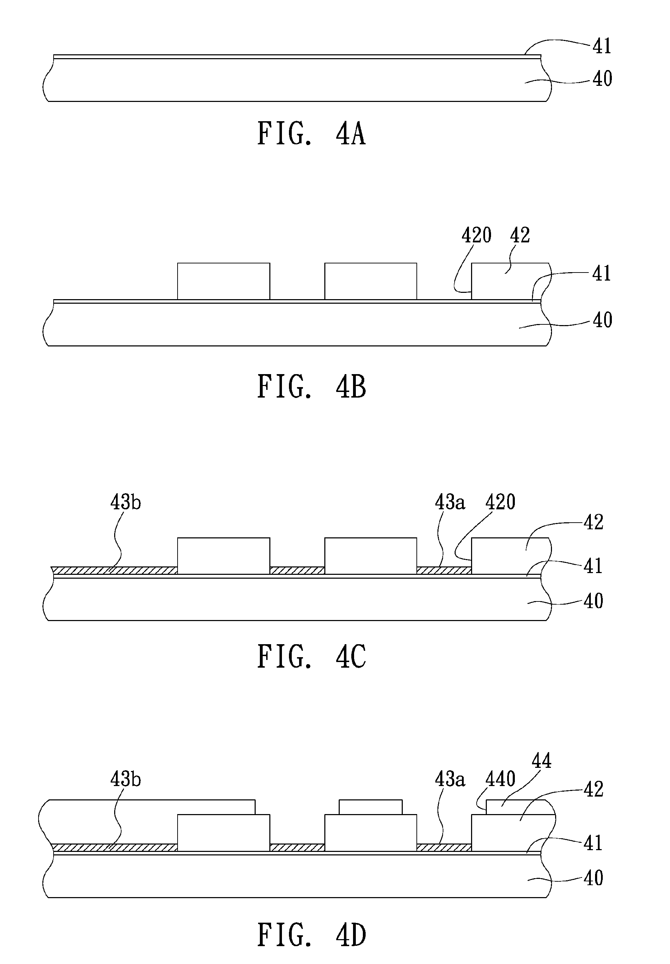

Referring to FIGs. 4A to 4I', FIGs. 4A to 4I are cross-sectional schematic views illustrating a semiconductor package substrate according to the first embodiment of the present invention.

As shown in FIG. 4A, a substrate 40 is first provided. Then, a conductive layer 41 is formed on the surface of the substrate 40. The conductive layer 41 is made of a material selected from the group consisting of Cu, Sn, Ni, Cr, Ti, and Cu-Cr alloy. Alternatively, the conductive layer 41 may be made of a conductive polymer. Preferably, the electrical conducting layer 41 is made of copper foil or electroless copper.

As shown in FIG. 4B, a first resist layer 42 (such as a dry film photoresist or a liquid photoresist) is formed on the surface of the conductive layer 41, and a plurality of openings 420 are formed in the first resist layer 42 to expose parts of the conductive layer 41.

As shown in Fig. 4C, by using the conductive layer 41 as an electrical conduction path for electroplating, at least one of the first electrically connecting pads 43a and traces 43b are formed on the surface of the conductive layer 41 in the openings 420 of the first resist layer 42, wherein the first electrically connecting pads 43a function as solder pads in the subsequent process.

As shown in FIG. 4D, a second resist layer 44 that appears in the form of a dry film or liquid photoresist is formed on the surfaces of the first resist layer 42, the first electrically connecting pads 43a and the traces 43b. Second openings 440 are formed in the second resist layer 44 to expose the first electrically connecting pads 43a, wherein the entire upper surfaces of the first electrically connecting pads 43a are exposed from the openings 440 of the second resist layer 44.

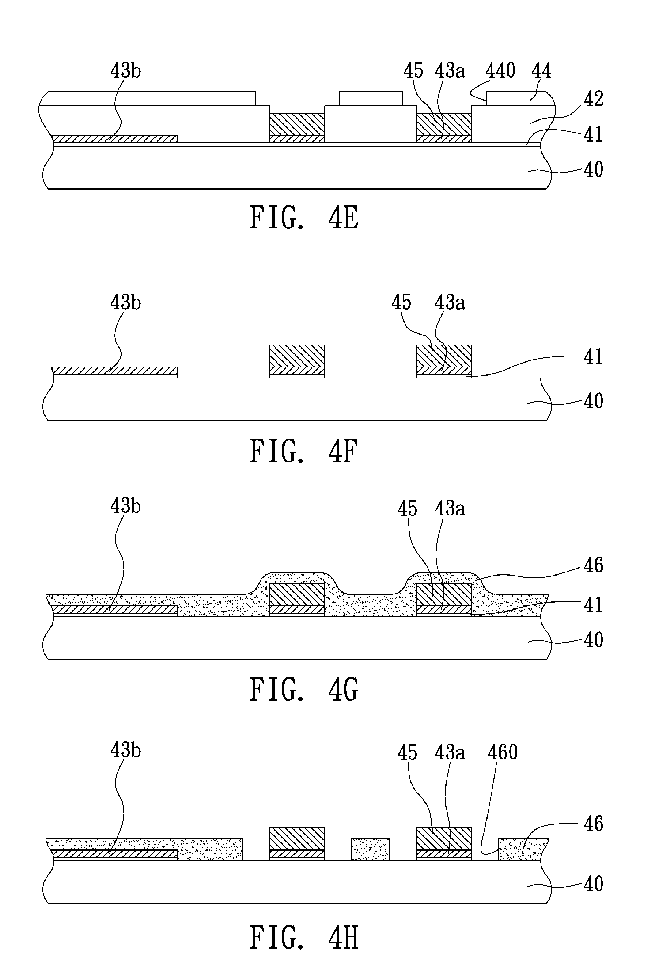

As shown in FIG. 4E, by using the conductive layer 41 as an electrical conduction path for electroplating, conductive posts 45 are formed on the surfaces of the first electrically connecting pads 43a in the openings 440 of the second resist layer 44.

As shown in FIG. 4F, the second resist layer 44, the first resist layer 42 and the conductive layer 41 covered by the first resist layer 42 are removed by stripping or etching so as to completely expose the conductive posts 45. Because the technique used in the removal of the first resist layer 42, the second resist layer 44 and the electrical conducting layer 41 is well known in the art, detailed description thereof is thereafter omitted.

As shown in FIG. 4G, an insulative protection layer 46 is then formed on the surfaces of the substrate 40 and the conductive posts 45. The insulative protection layer 46 may be made of a photosensitive dielectric material such as a solder mask layer. The photosensitive dielectric material may be in the form of liquid or a dry film. The liquid photosensitive dielectric material is formed on the surface of the circuit board 40 by a printing process or a non-printing process, wherein the non-printing process can be one of roller coating, spray coating, dipping coating and spin coating. The dry-film photosensitive dielectric material is adhered onto surface of the circuit board 40.

As shown in FIG. 4H, the insulative protection layer 46 is exposed and developed, such that openings 460 can be formed to completely expose the conductive posts 45 to become NSMD (non-solder mask defined) solder pads. After the insulative dielectric layer 46 on surfaces of the conductive posts 45 is removed, the exposed conductive posts 45 are higher than the insulative protection layer 46, such that the conductive posts 45 protrude from the insulative protection layer 46. The outer diameter of the conductive posts 45 is equal to that of the first electrically connecting pads 43a.

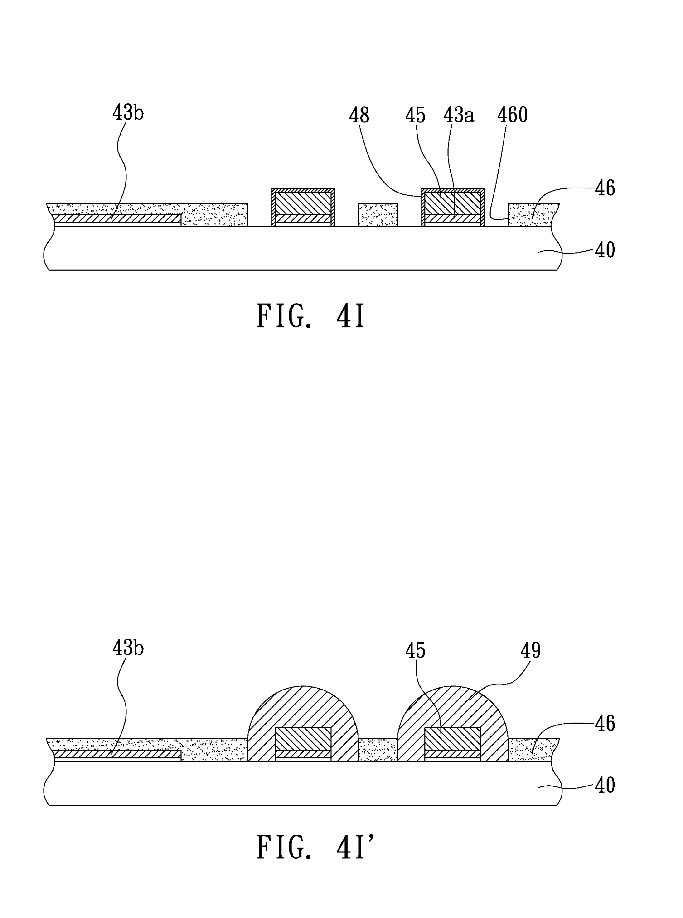

As shown in FIG. 4I, an adhesive layer 48 is formed on the surfaces of the conductive posts 45. The adhesive layer 48 is made of a material selected from the group consisting of chemically deposited Ni/Au, chemically deposited Sn, chemically deposited Ni/Pd/Au, electroplated Ni/Au, electroplated Sn, electroplated Sn/Pb, organic solder protection (OSP) layer, and direct immersion gold (DIG).

As shown in FIG. 4I', the conductive elements 49 may be formed on surfaces of the conductive posts 45 by electroplating or printing to be electrically connect to other electronic devices. The conductive elements 49 are solder bumps, which may be made of a material selected from the group consisting of Sn, Sn-Ag alloy, An-Ag-Cu alloy, Sn-Pb alloy and Sn-Cu alloy.

The semiconductor package substrate of the present invention comprises:
a circuit board 40 having a plurality of first electrically connecting pads 43a on at least a surface of the circuit board 40; conductive posts 45 formed on the first electrically connecting pads 43a; and an insulative protection layer 46 formed on the surface of the circuit board 40 and formed with openings 460 for completely exposing the conductive posts 45. The conductive posts 45 protrude from the insulative protection layer 46 and have the same outer diameter as the first electrically connecting pads 43a.

The semiconductor package substrate further comprises traces 43b and a conductive layer 41 formed between the circuit board 40, the first electrically connecting pads 43a and the traces 43b. The conductive layer 41 is made of a material selected from the group consisting of Cu, Sn, Ni, Cr, Ti, and Cu-Cr alloy. Alternatively, the conductive layer 41 may be made of a conductive polymer. The adhesive layer 48 is formed on the surfaces of the conductive posts 45. The adhesive layer 48 is made of a material selected from the group consisting of chemically deposited Ni/Au, chemically deposited Sn, chemically deposited Ni/Pd/Au, electroplated Ni/Au, electroplated Sn, electroplated Sn/Pb, organic solder protection (OSP) layer, and direct immersion gold (DIG). Alternatively, conductive elements 49 are formed on surfaces of the conductive posts 45, and the conductive elements 49 are solder bumps made of Sn, Sn-Ag alloy, Sn-Ag-Cu alloy, Sn-Pb alloy or Sn-Cu alloy.

### SECOND EMBODIMENT

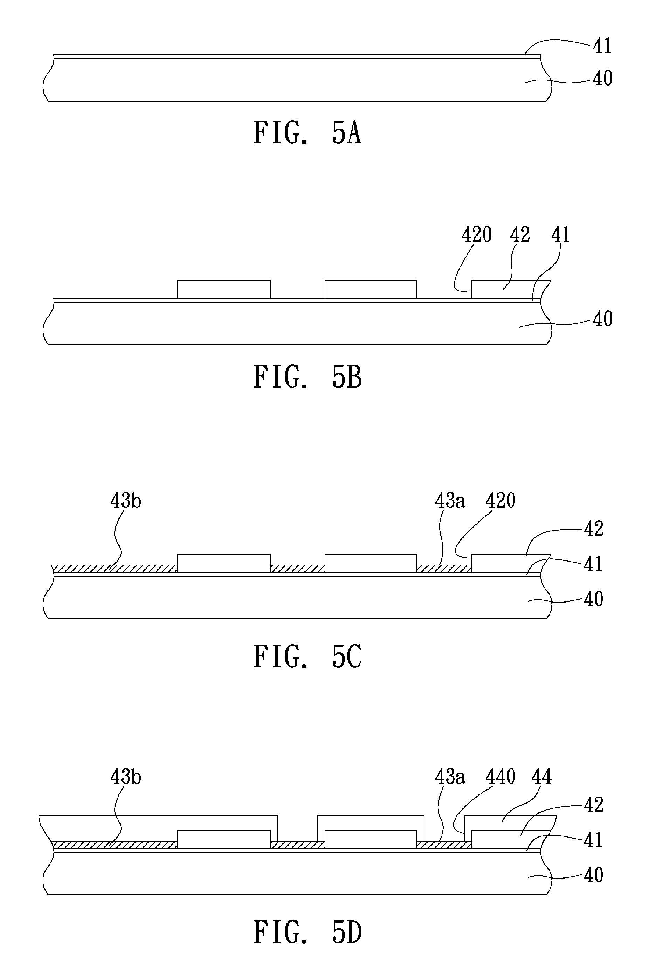

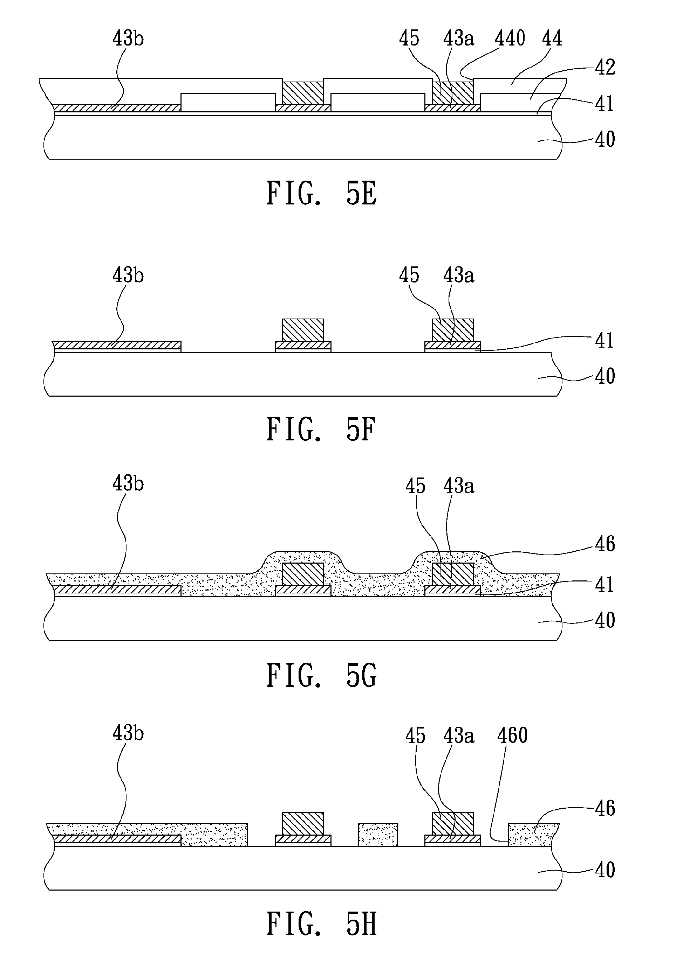

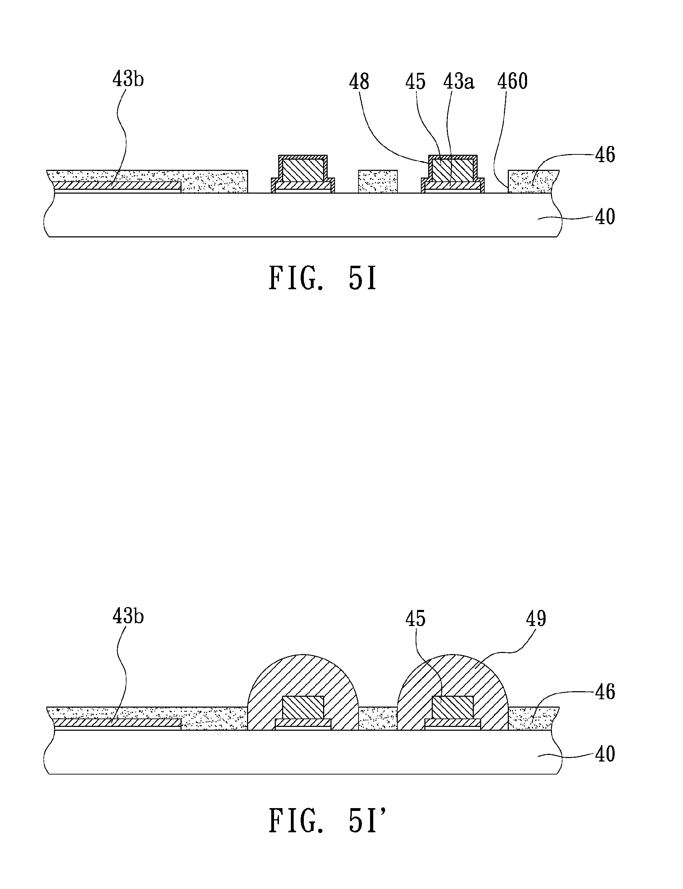

Referring to FIGs. 5A to 5I', FIGs. 5A to 5I are cross-sectional schematic views illustrating a semiconductor package substrate according to the second embodiment of the present invention.

The second embodiment shown in FIGs. 5A to 5C has the same fabrication process and structure as the first embodiment shown in Figs. 4A to 4C. However, the fabrication process and structure of the second embodiment shown in FIGs. 5D to 5I' is different from that of the first embodiment. As shown in FIG. 5D, a second resist layer 44 (such as a dry film photoresist or a liquid photoresist) is formed on the surfaces of the first resist layer 42, the first electrically connecting pads 43a and the traces 43b, and a plurality of openings 440 are formed in the second resist layer 44 to expose the first electrically connecting pads 43a, wherein of the upper surfaces of the first electrically connecting pads 43a are exposed from the openings 440 of the second resist layer 44. As shown in FIGs. 5E to 5G, the conductive posts 45 are formed in the openings 440 of the second resist layer 44 by electroplating, and outer diameter of the conductive posts 45 is smaller than that of the first electrically connecting pads 43a.

### THIRD EMBODIMENT

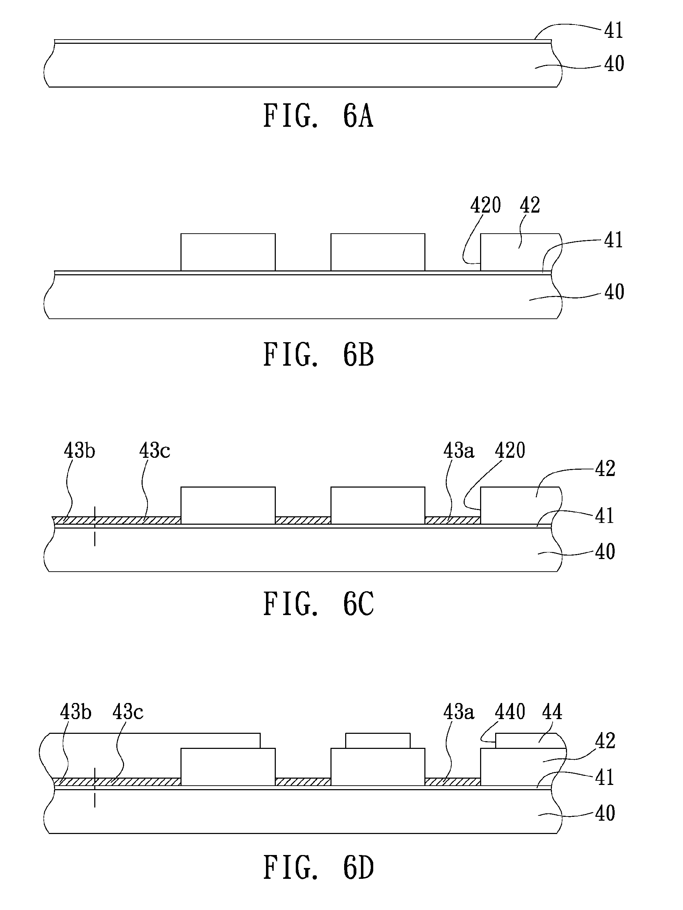

Referring to FIGs. 6A to 6I, FIGs. 6A to 6I are cross-sectional schematic views illustrating a semiconductor package substrate according to the third embodiment of the present invention The third embodiment differs from the first and second embodiments in that the first and second electrically connecting pads and the traces are disposed on the surface of the circuit board of the third embodiment.

As shown in FIG. 6A, the circuit board 40 is provided, and then the conducting layer 41 is formed on the surface of the circuit board 40.

As shown in FIG. 6B, the first resist layer 42 is formed on the surface of the conductive layer 41 and the openings 420 are formed in the first resist layer 42 to expose parts of the conductive layer 41.

As shown in FIG. 6C, with the conductive layer 41 functioning as an electrical conduction path for electroplating, the first electrical electrically connecting pads 43a, the traces 43b and the second electrically connecting pads 43c are formed on the surface of the conductive layer 41 in the openings 420 of the first resist layer 42, wherein the first electrically connecting pads 43a are used as solder pads and the second electrically connecting pads 43c as wire bonding pads in a subsequent process.

As shown in FIG. 6D,the second resist layer 44 is formed on the surfaces of the first resist layer 42, the first electrically connecting pads 43a, the traces 43b and the second electrically connecting pads 43c. The openings 440 are formed in the second resist layer 44, such that only the first electrically connecting pads 43a are exposed from the openings 440, wherein the entire upper surfaces of the first electrically connecting pads 43a are completely exposed from the openings 440.

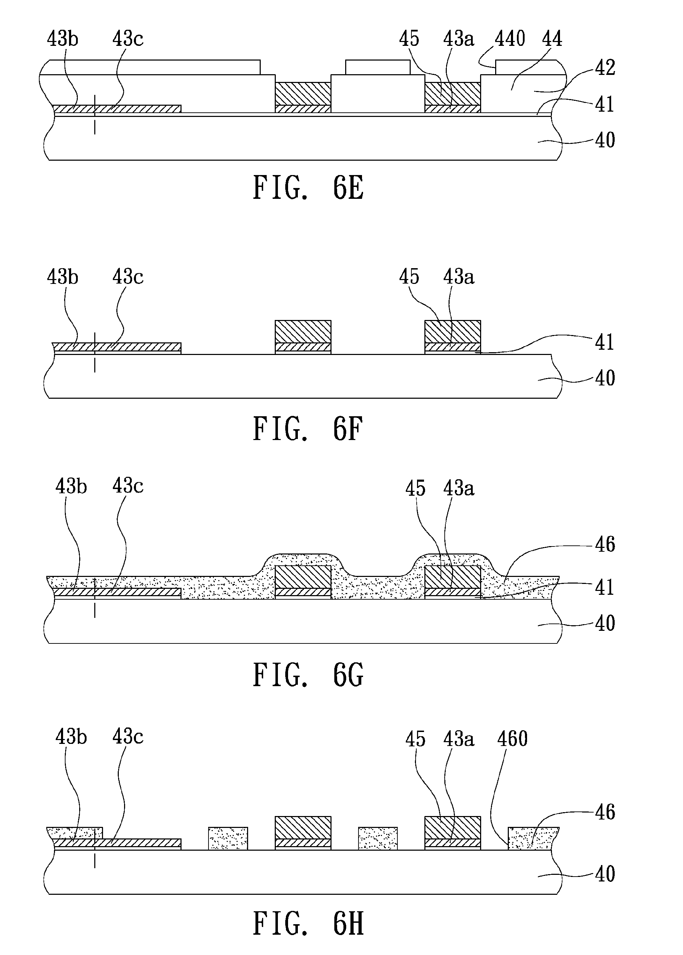

As shown in FIG. 6E, the conductive posts 45 are formed on the surfaces of the first electrically connecting pads 43a in the openings 440 by using the conductive layer 41 as an electrical conduction path for electroplating.

As shown in FIG. 6F, the second resist layer 44, the first resist layer 42 and the electrical conducting layer 41 covered by the first resist layer 42 are completely removed by stripping or etching, thereby the conductive posts 45, the traces 43b and the second electrically connecting pads 43c are completely exposed.

As shown in FIG. 6G, the insulative protection layer 46 is formed on the surfaces of the circuit board 40, the conductive posts 45 and the second electrically connecting pads 43c. The insulative protection layer 46 is made of a photosensitive dielectric material such as a solder mask. The photosensitive dielectric material may be in the form of a dry film or liquid, wherein the liquid photosensitive dielectric material can be formed on the surface of the circuit board 40 by a printing process or a non-printing process. The non-printing method may be one of the following methods: roller coating, spray coating, dipping coating and spin coating; the dry-film photosensitive dielectric material can be directly adhered onto the surface of the circuit board 40.

As shown in FIG. 6H, the insulative protection layer 46 is exposed and developed, so as to form openings 460 to completely expose the conductive posts 45 and the second electrically connecting pads 43c. The conductive posts 45 are higher than the insulative protection layer 46 and therefore protrude from the insulative protection layer 46. The conductive posts 45 have the same outer diameter as the first electrically connecting pads 43a. The second electrically connecting pads 43c are lower than the surface of the insulative protection layer 46.

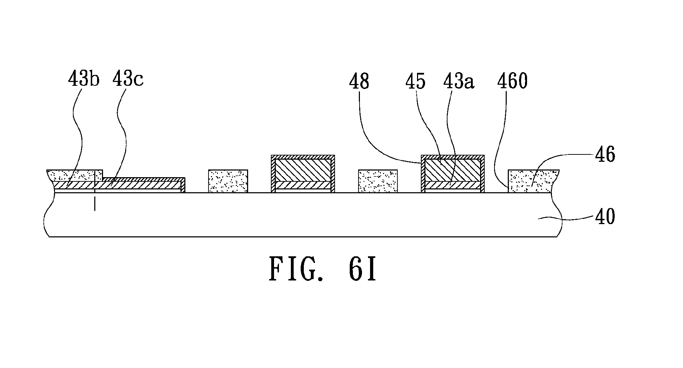

As shown in Fig. 6I, an adhesive layer 48 is formed on the surfaces of the conductive posts 45 and the second electrically connecting pads 43c, wherein the adhesive layer 48 is made of chemically deposited Ni/Pd/Au or chemically deposited Ni/Au.

Accordingly, the semiconductor package substrate comprises: a circuit board 40 having a plurality of first electrically connecting pads 43a and second electrically connecting pads 43c on at least a surface of the circuit board 40; conductive posts 45 formed on the first electrically connecting pads 43a; and an insulative protection layer 46 formed on the surface of the circuit board 40 and formed with openings 460 for completely exposing the conductive posts 45. The conductive posts 45 protrude from the insulative protection layer 46.

The semiconductor package substrate further comprises traces 43b thereon. The first electrically connecting pads 43a function as solder pads with the conductive posts 45 formed thereon, whereas the second electrically connecting pads 43c function as wire bonding pads. The semiconductor package substrate further comprises the conductive layer 41 formed between the circuit board 40 and the first electrically connecting pads 43a, the second electrically connecting pads 43c and the traces 43b. An adhesive layer 48 is formed on the surfaces of the conductive posts 45 and the second electrically connecting pads 43c, wherein the adhesive layer 48 is made of chemically deposited Ni/Pd/Au or chemically deposited Ni/Au.

### FOURTH EMBODIMENT

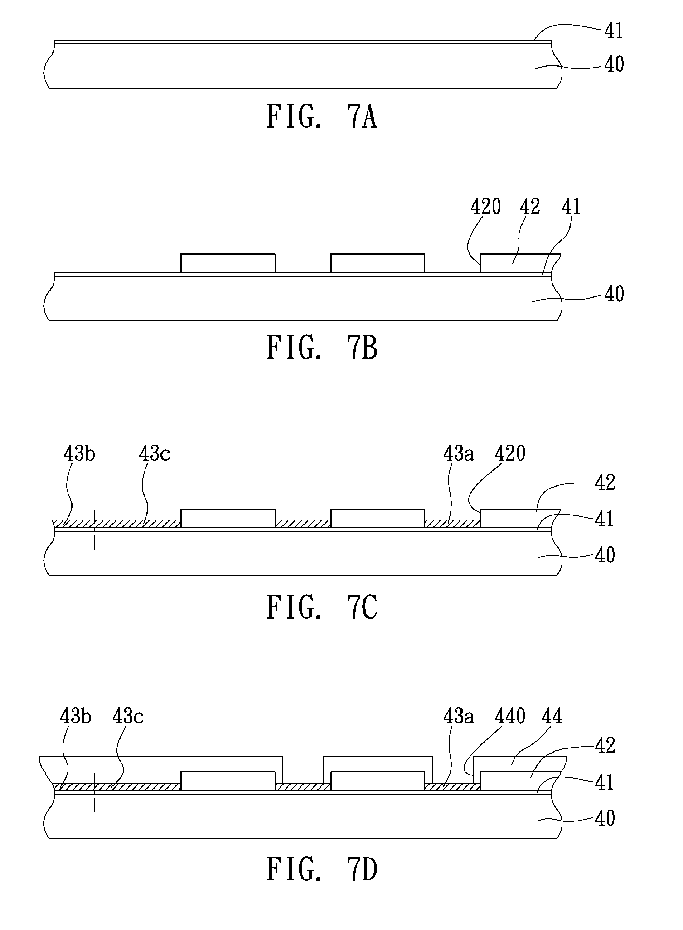

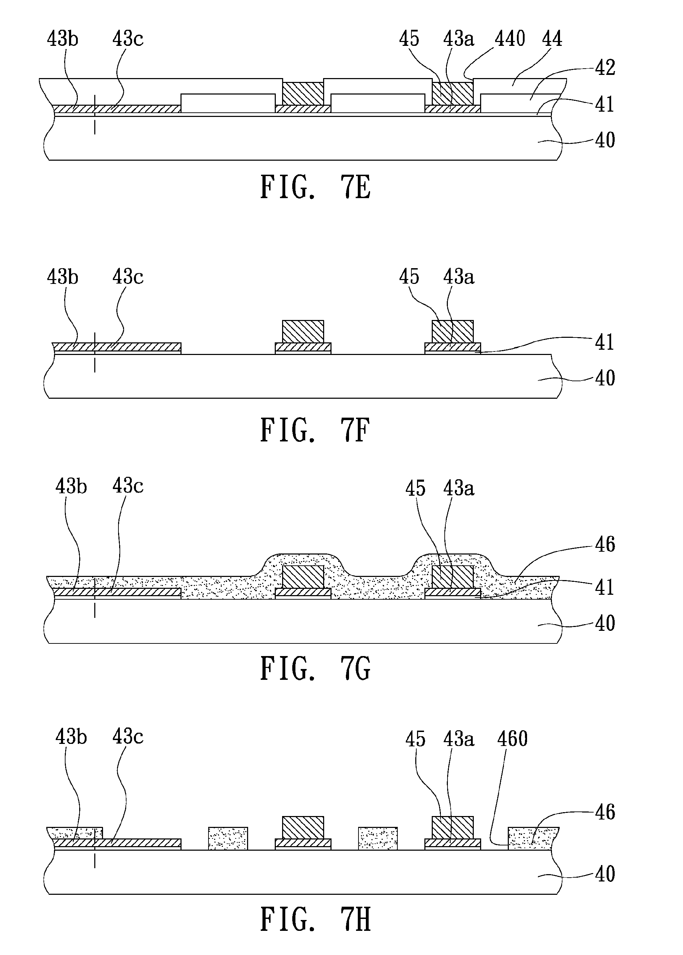

Referring to Figs. 7A to 7I, FIGs. 7A to 7I are cross-sectional schematic views illustrating a semiconductor package substrate according to the fourth embodiment of the present invention.

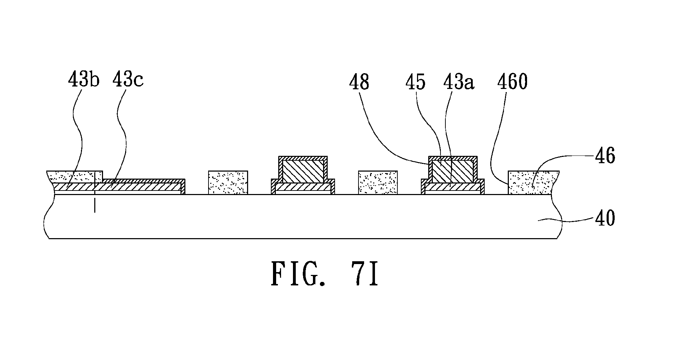

The fabrication process and the structure of the fourth embodiment shown in FIGs. 7A to 7C is the same as that of the third embodiment shown in FIGs. 6A to 6C, but the fabrication process and the structure of the fourth embodiment shown in Figs. 7D to 7I is different from that of the third embodiment. As shown in FIG. 7D, the second resist layer 44 (such as a dry film photoresist or a liquid photoresist) is formed on the surfaces of the first resist layer 42, the first electrically connecting pads 43a, and the traces 43b. The openings 440 are formed in the second resist layer 44 to expose the first electrically connecting pads 43a, wherein only parts of the upper surface of the first connecting pad 43a are exposed from the openings 440 of the second resist layer 44. As shown in FIGs. 7E to 7G, the conductive posts 45 are formed in the openings 440 of the second resist layer 44 by electroplating, thus allowing outer diameter of the conductive posts 45 to be smaller than that of the first electrically connecting pads 43a as shown in FIGs. 7H and 7I.

Accordingly, fabrication of a semiconductor package substrate in accordance with the present invention comprises the following steps: forming a conductive layer on the surface of a circuit board; forming traces, first electrically connecting pads and conductive posts (or even second electrical electrically connecting pads) by using the conductive layer as an electrical conduction path for electroplating; forming, after removing the conductive layer, an insulative protection layer on the surfaces of the circuit board and the conductive posts; forming openings in the insulative protection layer to completely expose the conductive posts, thus allowing the conductive posts to be higher than the insulative protection layer and become NSMD (non-solder mask defined) solder pads. Since the conductive posts are higher than the insulative protection layer, the conductive posts may easily be electrically connected to the bumps adapted for electrical connection with a semiconductor chip, and the quality and reliability of a subsequent packaging process is ensured.

The present invention has been described using exemplary preferred embodiments. However, it is to be understood that the scope of the present invention is not limited to the disclosed embodiments. On the contrary, the exemplary preferred embodiments are intended to cover various modifications and similar arrangements. The scope of the claims, therefore, should be accorded the broadest interpretation so as to encompass all such modifications and similar arrangements.

## Claims

1. A semiconductor package substrate, comprising:
a circuit board having a plurality of first electrically connecting pads formed on at least a surface of the circuit board;
a plurality of conductive posts formed on the first electrically connecting pads; and
an insulative protection layer formed on the surface of the circuit board and formed with openings for completely exposing the conductive posts, the conductive posts protruding from the insulative protection layer.

2. The semiconductor package substrate as claimed in claim 1, wherein the circuit board further comprises traces thereon.

3. The semiconductor package substrate as claimed in claim 1, wherein outer diameter of the conductive posts is one of equal to and smaller than that of the first electrically connecting pads.

4. The semiconductor package substrate as claimed in claim 1, wherein the first electrically connecting pads are solder pads.

5. The semiconductor package substrate as claimed in claim 1, wherein the circuit board further comprises a plurality of second electrically connecting pads thereon.

6. The semiconductor package substrate as claimed in claim 5, wherein the insulative protection layer is formed with the openings for exposing the second electrically connecting pads.

7. The semiconductor package substrate as claimed in claim 5, wherein the second electrically connecting pads are wire bonding pads and are lower than the surface of the insulative protection layer.

8. The semiconductor package substrate as claimed in claim 1, further comprising an adhesive layer formed on the surfaces of the conductive posts.

9. The semiconductor package substrate as claimed in claim 5, further comprising an adhesive layer formed on the surfaces of the conductive posts and the second electrically connecting pads.

10. The semiconductor package substrate as claimed in claim 8, wherein the adhesive layer is made of a material selected from the group consisting of chemically deposited Ni/Au, chemically deposited Sn, chemically deposited Ni/Pd/Au, electroplated Ni/Au, electroplated Sn, electroplated Sn/Pb, organic solder protection (OSP) layer, and direct immersion gold (DIG).

11. The semiconductor package substrate as claimed in claim 9, wherein the adhesive layer is made of one of chemically deposited Ni/Au and chemically deposited Ni/Pd/Au.

12. The semiconductor package substrate as claimed in claim 1, further comprising a plurality of conductive elements formed on the surfaces of the conductive posts.

13. The semiconductor package substrate as claimed in claim 12, wherein the conductive elements are solder bumps.
